# EUROPÄISCHE PATENTSCHRIFT

(11) **EP 1 275 970 B1**
(45) Veröffentlichungstag und Bekanntmachung des Hinweises auf die Patenterteilung: **14.12.2005**
(21) Anmeldenummer: 01810704.5
(22) Anmeldetag: 13.07.2001
(51) Int. Cl.: G01R 31/327

(54) **Prüfkreis für Fehlerstromschutzgeräte**
Test circuit for fault current protection device
Circuit de test pour appareil de protection de courant de défaut

(43) Veröffentlichungstag der Anmeldung: 15.01.2003
(73) Patentinhaber: ABB Schweiz AG, 5400 Baden (CH)
(72) Erfinder: Busenhart, Thomas, 8207 Schaffhausen (CH); Mayer, Siegfried, 78244 Gottmadingen 2 (DE); Mühle, Peter, 8200 Schaffhausen (CH)
(74) Vertreter: ABB Patent Attorneys

(56) Entgegenhaltungen:
- EP-A- 1 011 183
- DE-A- 3 813 403
- DE-A- 19 634 439
- US-A- 4 656 395
- PATENT ABSTRACTS OF JAPAN vol. 2000, no. 05, 14. September 2000 (2000-09-14) & JP 2000 040460 A (MATSUSHITA ELECTRIC WORKS LTD), 8. Februar 2000 (2000-02-08)

## Beschreibung

### TECHNISCHES GEBIET

Die vorliegende Erfindung bezieht sich auf das Gebiet des Fehlerstromschutzes. Sie betrifft einen Prüfkreis für Fehlerstromschutzgeräte gemäss dem Oberbegriff des Patentanspruchs 1 sowie ein Fehlerstromschutzgerät gemäss dem Oberbegriff des Patentanspruchs 6.

### STAND DER TECHNIK

Fehlerstromgeschützte Steck- oder Einbauvorrichtungen, wie Sicherheits-Stecker, Sicherheits-Zwischenstecker (Adapter) und Sicherheits-Steckdosen, verhüten Elektrounfälle und Brände in elektrischen Anlagen. Sie überwachen dabei angeschlossene Verbraucher kontinuierlich und unterbrechen die Stromzufuhr bevor ein zur Erde abfliessender Fehlerstrom für Menschen, Tiere oder Sachen gefährlich werden kann.

Die Funktionsweise eines Fehlerstromschutzschalters beruht darauf, dass der Magnetfluss eines Differenzstroms in der Sekundärwicklung eines Summenstromwandlers eine in einer Beschaltung aufbereitete Spannung erzeugt, welche oberhalb eines Schwellwertes einen Magnetauslöser aktiviert. Durch Betätigung einer Prüftastanordnung wird ein durch die Grösse eines Prüfwiderstandes geeignet bemessener Fehlerstrom simuliert, der bei intaktem Fehlerstrom-Schutzschalter ein Öffnen der Kontaktanordnung bewirkt.

In der Offenlegungsschrift DE-A 43 22 845 ist eine Anordnung zur Messung von Fehlerströmen mit einem zwischen Einspeisung und Verbraucher geschalteten Summenstromwandler und einem Prüfkreis umfassend einen Taster und einen Prüfwiderstand, dargelegt. Durch den Summenstromwandler führen zwei Leiter (Phasen- und Neutralleiter), und ein Ende des Prüfkreises ist einspeiseseitig mit dem Phasenleiter und verbraucherseitig mit dem Neutralleiter verbunden.

DE 3813403 zeigt einen ortsveränderlichen Differenzstromschalter mit einem Summenstromwandler, bei welchem ein Prüfkreis mit einem Prüfkontakt und einem Prüfwiderstand durch den Summenstromwandler geführt ist, wobei der erste und zweite Anschlusspunkt des Prüfkreises auf der Verbraucherseite des Summenstromwandlers liegen:

Das Patent US 5,293,522 betrifft die Anordnung und Ausbildung einer Prüftaste für einen vereinfachten Prüfkreis eines Fehlerstromschutzschalters mit zwei Messtransformatoren ("toroidal sensing coils"). Letztere sind am Rande einer Platine angeordnet, und Neutral- und

Phasenleiter führen jeweils durch deren zentrale Öffnungen. Ein Testleiter oder Prüfkreisabschluss ist ebenfalls durch den einen Messtransformator geführt und verbindet als flexibler Draht zwei ausserhalb des Transformators befindliche Endpunkte von gedruckten Leiterbahnen auf der Platine.

### DARSTELLUNG DER ERFINDUNG

Aufgabe der vorliegenden Erfindung ist es, einen Prüfkreis für Fehlerstromschutzgeräte anzugeben, welcher sich einfach und platzsparend realisieren lässt. Diese Aufgabe wird durch einen Prüfkreis für Fehlerstromschutzgeräte mit den Merkmalen des Patentanspruchs 1 gelöst.

Kern der Erfindung ist es, bei einem Prüfkreis, welcher zwei Anschlusspunkte auf zwei durch einen Summenstromwandler führenden Leitern verbindet, die genannten Anschlusspunkte entweder beide auf der Verbraucher- oder der Netzseite des Summenstromwandlers vorzusehen. Dadurch vereinfacht sich die Kontaktierung der Anschlusspunkte, dafür muss ein Prüfkreisabschluss genannter Teil des Prüfkreises ebenfalls durch den Summenstromwandler geführt werden.

In einer ersten Ausführungsform des erfindungsgemässen Prüfkreises ist der Summenstromwandler auf einer Platine oder einem Tragkörper angeordnet. Zwei auf die Platine gedruckte Prüfkreisabschnitte enden in der Nähe des Summenstromwandlers und werden durch den Prüfkreisabschluss verbunden. Letzterer stellt eine einfache, aus der Ebene der Platine hinausreichende Verbindung dar, welche im Rahmen der Bestückung der Platine angelötet werden kann. Für eine Automatisierung dieses Arbeitsschritt ist es vorteilhaft, wenn der Prüfkreisabschluss aus einem bestückungsfähigen, d.h. steifen oder formstabilen Drahtstück geformt ist und keine flexible Drahtschlaufe umfasst.

Gemäss einer bevorzugten Ausführungsform wird als Prüfkreisabschluss der Prüfkreiswiderstand selbst verwendet. Dadurch können zusätzliche Drahtstücke vermieden und die Gesamtzahl der eingesetzten Teile verringert werden. Die Schenkel des Prüfkreiswiderstandes müssen nicht extra elektrisch isoliert werden, dafür sollte auf einen ausreichenden Abstand zum Summenstromwandler geachtet werden.

Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen
Fig.1 ein Schema eines Prüfkreises eines Fehlerstromschutzschalters, und
Fig.2 eine Schrägaufsicht eines Fehlerstromschutzschalters.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

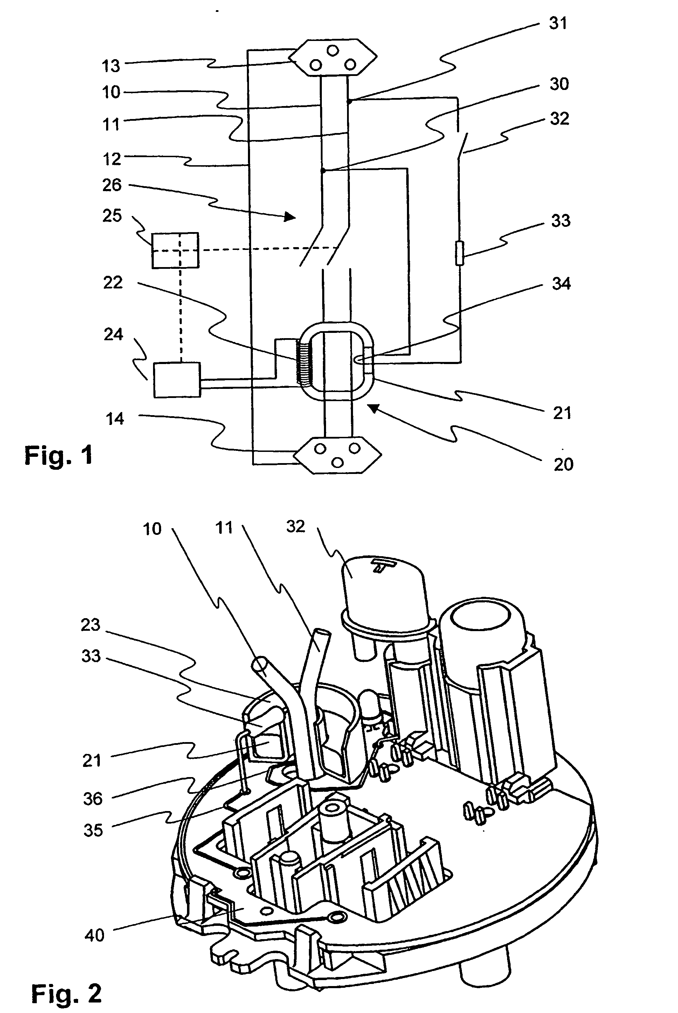

In Fig.1 ist ein Prüfkreis eines Fehlerstromschutzschalters nach der Erfindung gezeigt. Ein erster Leiter 10 und eine zweiter Leiter 11, beispielsweise Phase (L) und Neutralleiter (N), sowie ein Erdungsleiter 12 verbinden einen netzseitigen Anschluss 13 und einen verbraucherseitigen Ausgang 14 des Fehlerstromschutzschalters. Die beiden Leiter 10,11 führen durch einen Mess- oder Summenstromwandler 20, welcher im Wesentlichen einen magnetischen Kern 21 und eine Sekundärwicklung 22 umfasst. Letztere ist über eine Beschaltung 24 mit einem Magnetauslöser 25 oder Aktor verbunden, welcher wiederum die beweglichen Kontakte einer Schaltstelle 26 steuert.

Ein Prüfkreis 3 verbindet einen ersten Anschlusspunkt 30 auf dem ersten Leiter 10 mit einem zweiten Anschlusspunkt 31 auf dem zweiten Leiter 11. Er umfasst eine Prüftaste 32 mit einem selbstfedernden Schliesskontakt und ein Prüfkreis- oder Testwiderstand 33 sowie einen Prüfkreisabschluss 34, welcher ebenfalls durch den Summenstromwandler 20 führt.

In Fig.2 ist ein Ausschnitt eines Fehlerstromschutzschalters nach der Erfindung gezeigt. Auf einer Platine 40 (printed circuit board) sind die Prüftaste 32 und der aufgeschnitten dargestellte Summenstromwandler 20 angeordnet. Der Summenstromwandler 20 umfasst weiter eine Wandlerschale 23, welche die um den Kern 21 gewickelte Sekundärwicklung 22 aufnimmt. Der Prüfkreiswiderstand 33 verbindet zwei Abschnitte 35, 36 des Prüfkreises, welche als Leiterbahnen auf die Platine40 gedruckt sind. In der Fig.2 führt der zweite Prüfkreisabschnitt 36 unter dem Summenstromwandler 20 durch und in dessen Innenbereich, wo er in einem durch den Leiter 10 verdeckten Punkt mit einem Schenkel des Prüfwiderstandes 33 verlötet ist. Durch eine Ausnehmung in der Platine 40 führen die beiden Leiter 10, 11 von einer in Fig.2 dem Betrachter zugewandten Verbraucherseite zu einer Netz- oder Einspeiseseite.

Bei gedrückter Prüftaste 32 schliesst sich eine Kontaktstelle des Prüfkreises, ein vordefinierter Fehlerstrom von ungefähr 40 mA wird simuliert und veranlässt einen korrekt funktionierenden Fehlerstromschalter, die Kontakte der Schaltstelle 26 zu öffnen. Dieser Differenzstrom fliesst erfindungsgemäss nicht in einem der Leiter 10, 11 durch den Summenstromwandler 20, sondern im Prüfkreisabschluss 34..

Die vorgeschlagene Erfindung weist gegenüber einer Ausführungsform mit einem separat auf der Platine 40 angeordneten Testwiderstand weniger Einzelteile und Montageschritte auf. Durch die Verwendung eines bestückungsfähigen, selbsttragenden Prüfkreisabschlusses 34 anstelle von biegeschlaffen Drahtschlaufen oder Litzen kann dessen Einbau durch einen Bestückungsautomaten automatisiert durchgeführt werden. Die elektrische Isolierung des Prüfkreiswiderstandes 20 gegenüber dem Stromwandler 20 wird durch die Wandlerschale 23 bewerkstelligt. Dabei ist der vertikale Abstand des Prüfkreiswiderstandes zum Stromwandler 20 durch die Höhe der Wandlerschale 23 bestimmt und so bemessen, dass auf eine Isolierung der Schenkel des Prüfkreiswiderstandes verzichtet werden kann. Es kann also als Testwiderstand ein handelsüblicher Widerstand, dessen Schenkel auf die geforderte Länge abgebogen sind, eingesetzt werden.

Das Fehlerstromschutzgerät ist entweder als fehlerstromgeschützte Steckdose für den festen Einbau mit einer dauerhaften Verdrahtung der netzseitigen Anschlüsse vorgesehen oder aber als mobiler fehlerstromgeschützter Zwischenstecker. Letzterer ist netzseitig mit steckbaren Anschlüssen ausgestattet und insbesondere zur Nachrüstung bereits bestehender elektrischer Installationen geeignet.

### BEZUGSZEICHENLISTE

- 10, 11: Leiter
- 12: Erdungsleiter
- 13: Netzseitiger Anschluss
- 14: Verbraucherseitiger Ausgang
- 20: Summenstromwandler
- 21: Kern
- 22: Sekundärwicklung
- 23: Wandlerschale
- 24: Beschaltung
- 25: Magnetauslöser
- 26: Schaltstelle
- 3: Prüfkreis
- 30: Erster Anschlusspunkt
- 31: Zweiter Anschlusspunkt
- 32: Prüftaste mit Prüftastenfeder
- 33: Prüfkreiswiderstand
- 34: Prüfkreisabschluss
- 35, 36: Prüfkreisabschnitt
- 40: Platine

## Patentansprüche

1. Prüfkreis (3) für Fehlerstromschutzgeräte mit einer durch eine Prüftaste (32) schliessbaren Kontaktstelle und einem Prüfkreiswiderstand (33), wobei
der Prüfkreis in einem ersten Anschlusspunkt (30) von einem ersten Leiter (10) abzweigt und in einem zweiten Anschlusspunkt (31) in einen zweiten Leiter (11) einmündet,
die beiden Leiter (10, 11) durch einen Summenstromwandler (20) geführt sind und einen Verbraucher mit einer Einspeisung verbinden,
bei geschlossener Kontaktstelle ein Fehlerstrom durch den Summenstromwandler (20) fliesst,
der erste und zweite Anschlusspunkt (30, 31) des Prüfkreises beide jeweils auf einer Verbraucher- oder Einspeiseseite des Summenstromwandlers (20) liegen,
der Summenstromwandler (20) auf einer Platine (40) angeordnet ist,
ein durch den Summenstromwandler (20) führender Prüfkreisabschluss (34) zwei auf die Platine (40) gedruckte Prüfkreisabschnitte (35, 36) verbindet, und
die beiden Leiter (10, 11) durch den Summenstromwandler (20) von einer Verbraucherseite zu einer Einspeiseseite der Platine (40) führen,
**dadurch gekennzeichnet, dass**
einer der beiden auf die Platine (40) gedruckten Prüfkreisabschnitte (35, 36) unter dem Summenstromwandler (20) durch in dessen Innenbereich führt.

2. Prüfkreis nach Anspruch 1, **dadurch gekennzeichnet, dass** der Prüfkreisabschluss (34) aus bestückungsfähigem Draht gefertigt ist.

3. Prüfkreis nach Anspruch 2, **dadurch gekennzeichnet, dass** der Prüfkreisabschluss (34) den Prüfkreiswiderstand (33) umfasst.

4. Prüfkreis nach Anspruch 2, **dadurch gekennzeichnet, dass** der Prüfkreisabschluss (34) den Summenstromwandler (20) nicht beführt.

5. Prüfkreis nach Anspruch 1, **dadurch gekennzeichnet, dass** die beiden Leiter (10, 11) durch eine Ausnehmung in der Platine (40) hindurchgeführt sind.

6. Fehlerstromschutzgerät mit einem Prüfkreis (3) nach einem der vorhergehenden Ansprüche.

## Claims

1. Test circuit (3) for fault-current protection devices having a contact point, which can be closed by means of a test button (32), and a test-circuit resistor (33), the test circuit branching off from a first conductor (10) at a first connection point (30) and opening out into a second conductor (11) at a second connection point (31), the two conductors (10, 11) being passed through a core-balance current transformer (20) and connecting a load to a feed, a fault current flowing through the core-balance current transformer (20) when the contact point is closed, the first and second connection points (30, 31) of the test circuit both lying in each case on a load or feed side of the core-balance current transformer (20), the core-balance current transformer (20) being arranged on a printed circuit board (40), a test-circuit termination (34), which passes through the core-balance current transformer (20), connecting two test-circuit sections (35, 36) which have been printed on the printed circuit board (40), and the two conductors (10, 11) passing through the core-balance current transformer (20) from a load side to a feed side of the printed circuit board (40), **characterized in that** one of the two test-circuit sections (35, 36) which have been printed on the printed circuit board (40) passes through beneath the core-balance current transformer (20) in the inner region thereof.

2. Test circuit according to Claim 1, **characterized in that** the test-circuit termination (34) is produced from a wire which can be fitted to the printed circuit board.

3. Test circuit according to Claim 2, **characterized in that** the test-circuit termination (34) comprises the test-circuit resistor (33).

4. Test circuit according to Claim 2, **characterized in that** the test-circuit termination (34) does not touch the core-balance current transformer (20).

5. Test circuit according to Claim 1, **characterized in that** the two conductors (10, 11) are passed through a cutout in the printed circuit board (40).

6. Fault-current protection device having a test circuit (3) according to one of the preceding claims.

## Revendications

1. Circuit de test (3) pour appareils de protection de courants de défaut, comprenant un point de contact fermable par un bouton de contrôle (32) et une résistance de circuit de test (33), dans lequel
le circuit de test part d'un premier conducteur (10) au niveau d'un premier point de raccordement (30) et débouche dans un deuxième conducteur (11) au niveau d'un deuxième point de raccordement (31),
les deux conducteurs (10, 11) passent à travers un transformateur sommateur (20) et relient un consommateur à une alimentation,
lorsque le point de contact est fermé, un courant de défaut passe dans le transformateur sommateur (20),
le premier et le deuxième point de raccordement (30, 31) du circuit de test se trouvent tous deux respectivement sur un côté consommateur ou alimentation du transformateur sommateur (20),
le transformateur sommateur (20) est disposé sur une platine (40),
une terminaison du circuit de test (34) passant à travers le transformateur sommateur (20) relie deux portions du circuit de test (35, 36) imprimées sur la platine (40), et
les deux conducteurs (10, 11) passent à travers le transformateur sommateur (20) d'un côté consommateur à un côté alimentation de la platine (40),
**caractérisé en ce que**
l'une des deux portions de circuit de test (35, 36) imprimées sur la platine (40) passe sous le transformateur sommateur (20) à travers sa région intérieure.

2. Circuit de test selon la revendication 1,
**caractérisé en ce que** la terminaison du circuit de test (34) est fabriquée en un fil métallique susceptible d'être inséré.

3. Circuit de test selon la revendication 2,
**caractérisé en ce que** la terminaison du circuit de test (34) comprend la résistance du circuit de test (33).

4. Circuit de test selon la revendication 2,
**caractérisé en ce que** la terminaison du circuit de test (34) n'entre pas en contact avec le transformateur sommateur (20).

5. Circuit de test selon la revendication 1,
**caractérisé en ce que** les deux conducteurs (10, 11) sont guidés à travers un évidement dans la platine (40).

6. appareil de protection de courants de défaut comprenant un circuit de test (3) selon l'une quelconque des revendications précédentes.
